# FASCICULE DE BREVET EUROPEEN

(11) **EP 1 363 366 B1**
(45) Date de publication et mention de la délivrance du brevet: **05.05.2010**
(21) Numéro de dépôt: 03290929.3
(22) Date de dépôt: 15.04.2003
(51) Int. Cl.: H01S 5/0625

(54) **Procédé de stabilisation pour source laser à réflecteur distribué**
Stabilisationsverfahren für einen Laser mit verteilter Rückkopplung
Stabilisation process for a distributed feedback laser

(30) Priorité: 18.04.2002 FR 0204868
(43) Date de publication de la demande: 19.11.2003
(73) Titulaire: Oclaro (North America), Inc., Fremont, CA 94538 (US)
(72) Inventeur: Sillard, Hélène, 78150 Le Chesnay (FR); Leroy, Arnaud, 75014 Paris (FR); Raël, Philippe, 41100 Meslay (FR); Chambon, Stéphanie, 92330 Sceaux (FR)
(74) Mandataire: Feray, Valérie

(56) Documents cités:
- EP-A- 0 545 534
- EP-A- 1 130 725
- WO-A-01/76028
- US-A- 6 064 681
- JOHNSON J E ET AL: "FULLY STABILIZED ELECTROABSORPTION-MODULATED TUNABLE DBR LASER TRANSMITTER FOR LONG-HAUL OPTICAL COMMUNICATIONS" IEEE JOURNAL OF SELECTED TOPICS IN QUANTUM ELECTRONICS, IEEE SERVICE CENTER, US, vol. 7, no. 2, mars 2001 (2001-03), pages 168-177, XP001108209 ISSN: 1077-260X

## Description

L'invention se situe dans le domaine des sources d'émission d'ondes laser destinées notamment aux télécommunications optiques. Elle concerne plus particulièrement les sources accordables en longueur d'onde utilisant des lasers à réflecteur distribué, communément appelés lasers DBR (de l'anglais "Distributed Bragg Reflector").

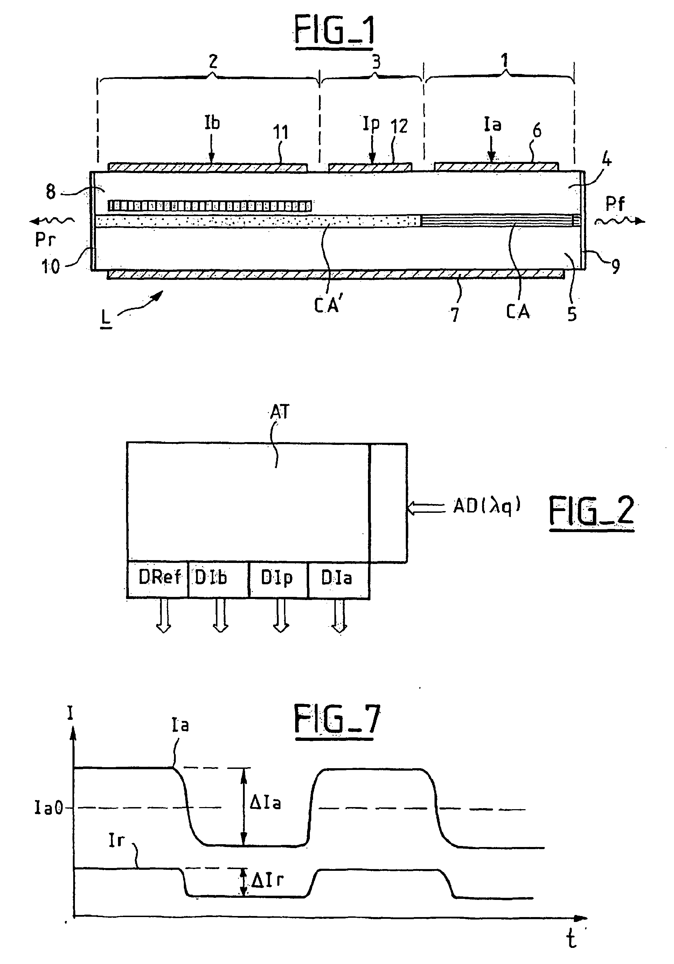

Un exemple de laser DBR est représenté schématiquement à la figure 1. C'est un composant semi-conducteur monolithique typiquement composé d'une section amplificatrice 1, dite "active", couplée à une section dite "de Bragg" 2. Optionnellement, une section dite "de phase" 3 peut être disposée entre les sections active et de Bragg.

La section active présente une structure verticale classiquement constituée d'une couche active amplificatrice CA disposée entre deux couches de gaine 4, 5 de dopages opposés. Cette couche active CA est habituellement composée d'une succession de puits quantiques séparés par des couches formant barrières de potentiel. Des électrodes supérieure 6 et inférieure 7 permettent une injection de courant Ia au travers de ces couches de façon à produire un effet d'amplification optique.

La section de Bragg 2 est une section réfléchissante présentant un maximum de réflectivité pour au moins une valeur de longueur d'onde de réflexion. Une de ses extrémités est donc couplée à la section active 1. Elle présente une structure verticale constituée d'une couche guidante CA' homogène (dite "massive" ou "bulk" en anglais) disposée entre deux couches de gaine. En outre, un réseau 8 est situé dans une des couches de gaine au voisinage de la couche guidante et forme le long du guide une alternance périodique de matériaux d'indices différents. Ce réseau 8 est conçu pour constituer un réflecteur sélectif en longueur d'onde présentant au moins un pic principal de réflectivité, c'est-à-dire une longueur d'onde de réflexion maximale. Cette longueur d'onde dite "de Bragg" λ_{B}, est déterminée par le pas du réseau Λ et l'indice effectif nb de la couche guidante CA', selon la formule classique λ_{B} = 2Λ.nb.

La face externe 9 de la section active 1 constitue un réflecteur non sélectif en longueur d'onde et forme avec la section de Bragg 2 une cavité résonante de Fabry-Pérot contenant la section active 1.

Selon un premier type de laser, la puissance laser créée dans la cavité est extraite essentiellement par cette face externe 9 qui est dite alors "face avant". Elle est rendue semi-réfléchissante au moyen d'une couche anti-reflet appropriée. Typiquement sa réflectivité est de l'ordre de 1,5 à 5% de façon à permettre à la fois l'oscillation laser et une émission à l'extérieur du composant de l'onde laser créée. L'extrémité de la section de Bragg qui n'est pas couplée à la section active constitue une seconde face externe 10 du composant, dite "face arrière", et pour éviter la formation de modes parasites, celle-ci est rendue fortement anti-réfléchissante.

Selon un autre type de laser, la puissance laser créée dans la cavité peut être extraite essentiellement par l'extrémité de la section de Bragg qui n'est pas couplée à la section active. Cette extrémité devient alors une face avant ou est couplée à d'autres sections intégrées au composant, telles que photodétecteur, amplificateur, modulateur. Dans ce cas, la face externe 9 de la section active 1 devient une face arrière qui peut être fortement réfléchissante, typiquement avec une réflectivité supérieure à 90 %.

Dans tous les cas, l'oscillation laser est possible pour un ensemble de modes résonants longitudinaux (modes Fabry-Pérot) dont les longueurs d'onde sont imposées par la longueur optique de la cavité. Une oscillation se produira selon l'un de ces modes en cas d'accord suffisant entre sa longueur d'onde et la longueur d'onde de Bragg λ_{B}.

Pour réaliser une source accordable en longueur d'onde, il suffit de pouvoir modifier la longueur d'onde de Bragg λ_{B}. Pour cela, la couche guidante CA' de la section de Bragg doit être composée d'un matériau transparent sur toute la gamme de longueurs d'onde de fonctionnement et présenter un indice effectif nb pouvant varier en fonction d'une commande. Le matériau est par exemple un milieu actif choisi pour que son indice dépende de la densité de porteurs qu'il contient. La couche guidante CA' est alors disposée entre les deux couches de gaine 4, 5 de dopages opposés et la section de Bragg comporte une électrode supérieure 11 coopérant avec l'électrode inférieure 7 précitée pour permettre une injection d'un courant électrique de commande Ib dans la couche guidante CA'.

Ainsi, en réglant le courant Ib, on peut ajuster la longueur d'onde de Bragg λ_{B} à une valeur proche d'une longueur d'onde sélectionnée parmi celle des modes Fabry-Pérot de la cavité et par conséquent faire osciller le laser avec cette longueur d'onde choisie.

Un ajustement plus fin de la longueur d'onde d'oscillation peut par ailleurs être réalisée par un réglage de la température du composant. En agissant sur la température, on peut ajuster les indices des couches guidantes de la cavité et donc sa longueur optique, ce qui a pour effet de décaler le peigne de longueurs d'onde des modes Fabry-Pérot.

Une autre solution, telle qu'illustrée sur la figure 1, permettant d'ajuster plus facilement la longueur d'onde d'oscillation consiste à prévoir une section de phase 3 indépendante. Selon l'exemple représenté, la section de phase 3 prolonge la section de Bragg en direction de la section active 1, avec une structure verticale identique mais où le réseau de Bragg est absent. Elle comporte aussi une électrode supérieure 12 coopérant avec l'électrode inférieure 7 du composant pour permettre une injection de courant électrique Ip dans la couche guidante CA'. Ainsi, en agissant sur le courant électrique Ip injecté, on modifie la longueur optique de la cavité, ce qui décale le peigne de longueurs d'onde des modes Fabry-Pérot sans influencer la longueur d'onde de Bragg λ_{B}.

Le fonctionnement d'un laser accordable d'un type décrit ci-dessus sera donc déterminé par trois paramètres : le courant Ia injecté dans la section active 1, le courant Ib injecté dans la section de Bragg 2 et le courant Ip injecté dans la section de phase 3, ou à défaut de section de phase, la température.

En pratique, on impose une émission laser de puissance fixée et de longueur d'onde sélectionnable parmi une grille normalisée (grille ITU). Pour faciliter les changements de longueur d'onde de fonctionnement, on peut constituer une table d'allocation AT schématisée à la figure 2, adressable en fonction des longueurs d'onde sélectionnables λq de la grille et associant à chacune d'entre elles un ensemble de valeurs de trois paramètres DIa, DIb, DIp représentatifs des courants Ia, Ib, Ip à appliquer. Une fois mise en mémoire, cette table peut alors coopérer avec un circuit électronique qui pilote le composant, l'assemblage du circuit électronique et du composant sous la forme d'un module constituant ainsi un ensemble fonctionnel autonome.

Pour chaque longueur d'onde sélectionnable, les valeurs des trois paramètres doivent en outre être choisies de sorte que le laser présente un fonctionnement monomode. Un paramètre représentatif de ce fonctionnement est appelé le "taux de réjection des modes secondaires" ou en abrégé "SMSR" (de l'anglais "Side Mode Suppression Ratio"). Le SMSR est défini comme le rapport de la puissance du mode oscillant principal à celle du mode oscillant secondaire de plus forte puissance (voisin du mode principal). Pour assurer une qualité voulue de transmission, on impose une valeur minimale à ce rapport généralement exprimé en décibels, par exemple 35 dB.

Un problème qui se pose est celui des dérives des propriétés du composant, en particulier dues à son vieillissement. Ainsi, pour des valeurs fixées des courants, on observe que la puissance d'émission laser diminue au cours du temps. Pour remédier à ce problème, on est donc amené à ajuster en conséquence le courant Ia injecté dans la section active. Mais le fait de modifier le courant Ia ayant pour effet de modifier aussi l'indice de la section active, il en résulte un changement de la longueur d'onde d'émission, ce qui conduit à prévoir un asservissement en longueur d'onde qui ajuste le courant Ip injecté dans la section de phase en fonction d'une mesure de la longueur d'onde d'émission.

Toutefois, les dispositions précédentes ne permettent pas d'assurer un contrôle automatique du SMSR. Il convient donc de prévoir un autre asservissement qui ajuste avec précision la longueur d'onde de Bragg λ_{B} en fonction d'une mesure du SMSR, de façon à le rendre maximal, ou en tout cas au moins égal à la valeur imposée. Un asservissement utilisant une mesure directe du SMSR au moyen d'un analyseur de spectre optique n'est toutefois pas envisageable car un tel dispositif est impossible en pratique à intégrer dans un module d'émission laser. Il donc préférable de rechercher une mesure indirecte du SMSR au moyen d'un autre paramètre utilisable pour maximiser le SMSR, mais plus facile à mesurer.

Plusieurs solutions à ce problème ont été envisagées. Une première solution est décrite dans l'article intitulé "Fully Stabilized Electroabsorption-Modulated Tunable DBR Laser Transmitter for Long-Haul Optical Communications", John E. Johnson et al, IEEE JOURNAL ON SELECTED TOPICS IN QUANTUM ELECTRONICS, VOL. 7, NO. 2, MARCH/APRIL 2001, pages 168-177. Il est proposé de régler le courant Ib de façon à maintenir la puissance laser Pf émise par la face avant maximale. Cependant, ceci nécessite une mesure directe de la puissance d'émission qui impose la présence de moyens de couplage pour prélever une partie de l'onde issue de la face avant 9. Il peut en résulter une augmentation de la complexité et de l'encombrement du module.

Une autre solution ne présentant pas cet inconvénient est décrite dans la demande de brevet européen EP-A-545534. Elle consiste à régler le courant Ib de façon à rendre minimale la puissance laser Pr émise par la face arrière. Pour mesurer cette puissance, on peut utiliser un photodétecteur couplé à la face arrière ou intégré à l'extrémité du composant à l'arrière de la section de Bragg.

Toutefois, à cause de phénomènes non linéaires complexes, les critères choisis pour ces deux solutions ne sont pas utilisables lorsque le laser fonctionne à forte puissance, par exemple au delà de 20 mW. De plus, la mise en oeuvre de ces solutions visant à régler le courant Ib à une valeur telle qu'une puissance mesurée présente un extremum implique une modulation de ce courant Ib. Or, si cette modulation est à haute fréquence, cela a pour effet d'élargir le spectre d'émission. Si par contre la fréquence de modulation est suffisamment basse pour éviter ce problème, le temps de réponse de l'asservissement devient plus long, ce qui constitue un inconvénient si on veut un court temps de commutation pour passer d'une longueur d'onde à une autre.

US 6064681 décrit un système WDM. Dans la pratique, le SMSR maximum pour chaque canal ne se produit pas nécessairement lorsque la dérivée du courant de pilotage dPout/dItune s'annule. En réalité, pour la plupart des canaux le SMSR maximum ne se produit aux valeurs pour lesquelles ladite dérivée première s'annule. Selon un aspect décrit dans le présent document, un transmetteur optique stabilisé en longueur d'onde comprend un laser DBR et une boucle d'asservissement pilotant la longueur d'onde centrale du laser, comprend encore une mémoire dans laquelle sont stockées les valeurs non nulles de la dérivée dPout/dItune pour lesquelles le SMSR présente un maximum pour chacun des différents canaux et un contrôleur utilisant les valeurs stockées pour délivrer au laser un niveau de courant de pilotage maximisant le SMSR pour un canal particulier.

EP 1130725 décrit un procédé de pilotage des valeurs du courant de pilotage d'une source laser multi canal. Pour chaque canal, une valeur de consigne de pente de la puissance laser fonction du courant de pilotage est stockée. Les valeurs de consigne de pente de puissance laser en fonction du courant de pilotage sont ensuite mesurées. Le courant de pilotage est alors réglé jusqu'à mesurer une valeur de pente sensiblement égale à ladite valeur de consigne de pente. Le courant de pilotage opérationnel est obtenu pour la source laser correspondant à la valeur de pente mesurée.

Aussi le problème que l'invention vise à résoudre est de réaliser un asservissement tel que, pour chaque longueur d'onde sélectionnée et même à forte puissance d'émission, le laser soit maintenu de façon stable éloigné de points de fonctionnement correspondant à des sauts de mode. En d'autres termes, l'asservissement doit être en mesure de stabiliser le SMSR à sa valeur maximale ou du moins proche de celle-ci.

Pour cela, il convient d'abord de rechercher un nouveau paramètre de fonctionnement du laser, facilement mesurable et qui puisse servir à un asservissement tel que défini ci-dessus, tout en présentant une bonne tolérance aux dérives des caractéristiques du composant. Ce paramètre doit donc être représentatif du SMSR, notamment dans le cas de fortes puissances d'émission et sa mesure ne doit pas entraîner de perturbation sensible à l'onde laser produite.

Des études expérimentales effectuées sur des lasers DBR du premier type ont montré, en faisant varier le courant Ia injecté dans la section active 1 et en mesurant la puissance Pr émise par la face arrière, que la dégradation du SMSR au voisinage des sauts de mode s'accompagne d'une forte fluctuation de cette puissance arrière.

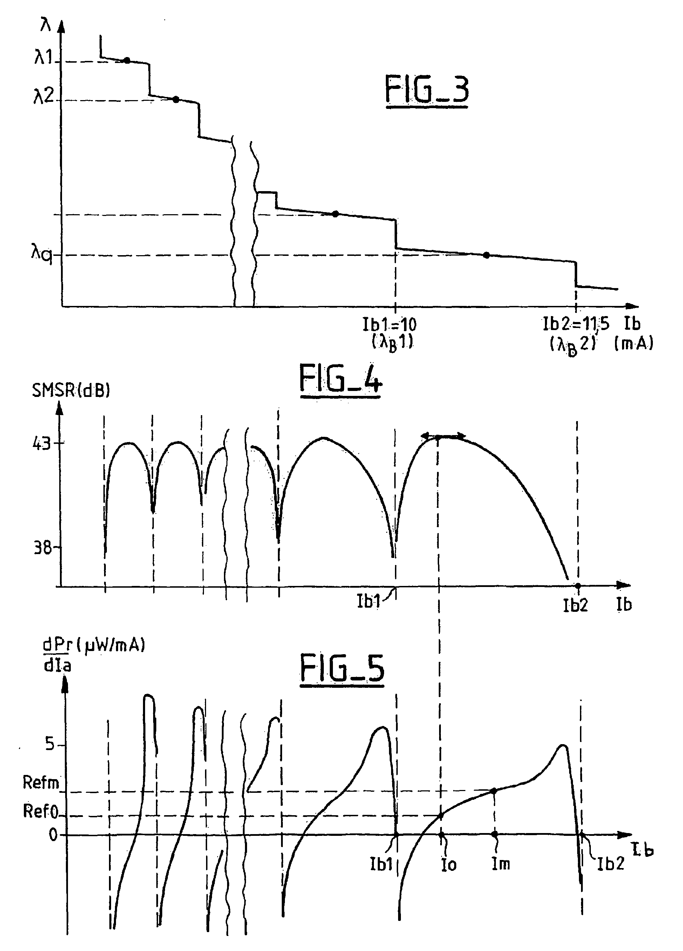

Les figures 3 à 5 vont permettre d'illustrer les phénomènes observés dans le cas d'un composant particulier de type classique réalisé en InP.

La figure 3 montre une courbe représentative des variations de la longueur d'onde λ du mode oscillant principal de la cavité en fonction du courant Ib (exprimé en mA) injecté dans la section de Bragg. La longueur d'onde de Bragg λ_{B} étant une fonction décroissante de ce courant Ib, on vérifie que la longueur d'onde λ décroît lorsque Ib croît. Par ailleurs, les sauts de modes se manifestent par des discontinuités de la courbe. Chaque longueur d'onde sélectionnable λ₁, λ₂, ..., λ_{q}, par exemple λ_{q}, est comprise entre deux valeurs de longueurs d'onde de Bragg consécutives, par exemple λ_{B}1, λ_{B}2, qui correspondent respectivement à des sauts de mode, lesquels correspondent sur la courbe à des valeurs particulières, par exemple Ib1 et Ib2, du courant de Bragg Ib. Ainsi, pour l'exemple représenté, au voisinage de la longueur d'onde sélectionnée λ_{q}, les sauts de mode se produisent lorsque Ib vaut 10 ou 11,5 mA.

La figure 4 montre une courbe représentative des variations du SMSR (exprimé en dB) en fonction du courant Ib. Pour chaque longueur d'onde sélectionnable λ₁, λ₂, ..., λ_{q}, on observe des diminutions très rapides du SMSR au voisinage des valeurs du courant de Bragg qui correspondent aux sauts de mode. Par ailleurs, on remarque que le SMSR est généralement maximal pour les valeurs de Ib situées sensiblement entre deux valeurs consécutives de Ib correspondant à des sauts de mode. Cependant, le SMSR peut aussi être maximal pour des valeurs de Ib différentes à celles situées sensiblement entre deux valeurs consécutives de Ib correspondant à des sauts de mode.

La figure 5 montre enfin une courbe représentative des variations en fonction du courant Ib de la dérivée dPr/dIa de puissance Pr émise par la face arrière par rapport au courant Ia injecté dans la section active. On voit que la valeur absolue de cette dérivée dPr/dIa est d'autant plus élevée que le laser a un fonctionnement proche d'un saut de mode. Par ailleurs, pour une puissance d'émission Pa donnée, on voit qu'il existe pour chaque mode laser une plage de valeurs de cette dérivée qui correspondent à des valeurs du SMSR voisines de sa valeur maximale.

Ainsi, en prenant une des valeurs de cette plage comme valeur de consigne Ref, on peut résoudre le problème posé en ajustant courant de Bragg Ib, donc la longueur d'onde de Bragg λ_{B}, de sorte que la dérivée dPr/dIa reste voisine de cette valeur de consigne.

Des observations analogues aux précédentes peuvent être faites si on s'intéresse non pas à la puissance arrière Pr mais à la puissance avant Pf. En fait, dans les deux cas on évalue la dérivée par rapport au courant Ia d'une mesure de la puissance laser créée dans la cavité ou encore indirectement de la réflectivité de la section de Bragg vis-à-vis de la longueur d'onde du mode principal qui est en oscillation.

Plus précisément l'invention a pour objet un procédé pour stabiliser le fonctionnement d'une source d'émission laser accordable en longueur d'onde, ladite source comprenant :
- un composant semi-conducteur L muni d'une section amplificatrice 1 délimitée par un premier et un second réflecteur 2, 9 formant une cavité résonante permettant plusieurs modes oscillants qui déterminent respectivement plusieurs longueurs d'onde sélectionnables λ₁, λ₂, λ_{q}, ledit premier réflecteur étant une section réfléchissante 2 intégrée au composant et présentant un maximum de réflectivité pour au moins une valeur de longueur d'onde de réflexion λ_{B}, cette section réfléchissante 2 ayant une première extrémité couplée à ladite section amplificatrice 1 et une seconde extrémité 10, un courant électrique Ia étant injecté dans ladite section amplificatrice 1, ladite section réfléchissante 2 étant commandable de façon à pouvoir régler ladite valeur de longueur d'onde de réflexion λ_{B} et ainsi favoriser l'oscillation d'un desdits modes oscillants présentant une longueur d'onde sélectionnée λ_{q}, une puissance laser étant alors créée dans la cavité,
ce procédé étant caractérisée en ce qu'il consiste à ajuster ladite longueur d'onde de réflexion λ_{B} de sorte que pour chaque longueur d'onde sélectionnée λ_{q}, la dérivée dPr/dIa de ladite puissance laser par rapport au courant Ia injecté dans la section amplificatrice 1 soit maintenue égale à une valeur de consigne Ref pour laquelle ladite source présente un taux de réjection des modes secondaires SMSR voisin de la valeur maximale que ce taux peut prendre pour ladite longueur d'onde sélectionnée λ_{q}.

En pratique, la valeur de consigne à adopter n'est pas nécessairement très précise. Le choix pour cette valeur déprendra principalement des caractéristiques du composant, de l'étendue de la gamme de longueurs d'onde sélectionnables et surtout de la valeur minimale du SMSR que l'on se fixe.

Ainsi, dans certains cas les plus simples, la valeur de consigne Ref peut être une valeur unique commune à toutes les longueurs d'onde sélectionnables λ₁, λ₂, λ_{q}.

Toutefois, cette solution peut ne pas convenir pour certains types de composant et/ou pour une utilisation sur une large gamme de longueurs d'onde sélectionnables. Aussi, on pourra prévoir en variante que chaque longueur d'onde sélectionnable λ₁, λ₂, λ_{q} est associée à une valeur de consigne Ref spécifique.

Par ailleurs, on voit d'après la courbe de la figure 5 que pour toute longueur d'onde sélectionnable λ₁, λ₂, λ_{q} telle que λ_{q}, il existe une valeur Ref0 de la dérivée dPr/dIa pour laquelle le SMSR est maximal. Ainsi, on pourra choisir comme valeur de consigne pour chaque longueur d'onde sélectionnable la valeur Ref0 associée.

Toutefois, ce choix n'est pas nécessairement toujours indispensable ni la meilleure solution. En effet, on a vu que toute longueur d'onde sélectionnable λ₁, λ₂, λ_{q} est comprise entre deux valeurs de longueurs d'onde de réflexion consécutives λ_{B}1, λ_{B}2 qui correspondent respectivement à des sauts de mode pour des valeurs consécutives Ib1 et Ib2 du courant Ib, mais que parfois le SMSR maximal peut être obtenu pour des valeurs du courant Ib, donc pour des longueurs d'onde de réflexion, voisines de valeurs qui entraînent des sauts de mode. Dans ces cas, choisir Ref0 comme valeur de consigne présente le risque de se placer en des points de fonctionnement instables ou peu tolérants à des dérives ou fluctuations de certains paramètres.

Or, on observe que lorsque le courant Ib est sensiblement égal à la moyenne Im des valeurs consécutives Ib1 et Ib2 correspondent à des sauts de mode, la valeur du SMSR reste toujours voisine de sa valeur maximale. Ainsi, choisir comme valeur de consigne la valeur Refm de la dérivée dPr/dIa obtenue avec cette valeur moyenne Im du courant Ib n'est pas fortement pénalisant en pratique, mais garantit d'être placé en des points de fonctionnement éloignés des sauts de mode.

En d'autres termes et selon une variante de l'invention qui privilégie la stabilité de fonctionnement, ladite valeur de consigne est celle Refm pour laquelle la longueur d'onde de réflexion λ_{B} est sensiblement égale à la moyenne λm des valeurs de longueurs d'onde de réflexion consécutives λ_{B}1, λ_{B}2 qui correspondent respectivement à des sauts de mode.

Par ailleurs, la dérivée dPr/dIa de la puissance laser par rapport au courant Ia injecté dans la section amplificatrice impose d'effectuer une évaluation de cette puissance laser. Il convient que cette évaluation soit aussi simple que possible à réaliser avec le type de laser choisi. En pratique, on pourra évaluer facilement la puissance laser soit en mesurant la puissance optique issue de la seconde extrémité 10 de la section réfléchissante 2, soit en mesurant la puissance optique issue du second réflecteur 9.

L'invention a aussi pour objet une source d'émission laser accordable en longueur d'onde prévue pour mettre en oeuvre le procédé de stabilisation selon l'invention. Elle comprend :
- un composant semi-conducteur L muni d'une section amplificatrice 1 délimitée par un premier et un second réflecteur 2, 9 formant une cavité résonante permettant plusieurs modes oscillants qui déterminent respectivement plusieurs longueurs d'onde sélectionnables λ₁, λ₂, λ_{q}, ledit premier réflecteur étant une section réfléchissante 2 intégrée au composant et présentant un maximum de réflectivité pour au moins une valeur de longueur d'onde de réflexion λ_{B}, cette section réfléchissante 2 ayant une première extrémité couplée à ladite section amplificatrice 1 et une seconde extrémité 10, ladite section réfléchissante 2 étant commandable électriquement de façon à pouvoir régler ladite valeur de longueur d'onde de réflexion λ_{B},
- un détecteur pour évaluer une puissance laser créée dans la cavité, et
- un circuit électronique pour injecter un courant électrique Ia dans la section amplificatrice 1 et pour commander ladite longueur d'onde de réflexion λ_{B} de façon à favoriser l'oscillation d'un desdits modes oscillants présentant une longueur d'onde sélectionnée λ_{q}.

Selon l'invention ladite source comporte des moyens d'asservissement conçus pour ajuster ladite longueur d'onde de réflexion λ_{B} de sorte que pour chaque longueur d'onde sélectionnée λ_{q}, la dérivée dPr/dIa de ladite puissance laser par rapport au courant Ia injecté dans la section amplificatrice 1 soit égale à une valeur de consigne Ref pour laquelle ladite source présente un taux de réjection des modes secondaires SMSR voisin de la valeur maximale que ce taux peut prendre pour ladite longueur d'onde sélectionnée λ_{q}.

Selon un mode de réalisation particulier adapté au cas où la section réfléchissante 2 est commandable par injection de courant électrique Ib, la source d'émission laser selon l'invention comporte des première et seconde sources de courant ajustables disposées pour injecter des premier et de second courants Ia, Ib respectivement dans ladite section amplificatrice 1 et dans ladite section réfléchissante 2. Le circuit électronique comprend une unité de commande pour commander ces sources de courant ajustables en fonction d'une donnée de consigne représentative de ladite longueur d'onde sélectionnée λ_{q} et d'une mesure de ladite dérivée dPr/dIa de puissance laser. L'unité de commande est en outre munie d'une unité de traitement numérique coopérant avec une table d'allocation comportant des données représentatives de valeurs de consigne Ref associées respectivement auxdites longueurs d'onde sélectionnables λ₁, λ₂, λ_{q}.

D'autres aspects et avantages de l'invention apparaîtront dans la suite de la description en référence aux figures.
- La figure 1 représente schématiquement un composant laser DBR déjà décrit précédemment.
- figure 2 représente schématiquement une table d'allocation déjà décrite précédemment.
- Les figures 3 à 5 représentent des courbes déjà décrites précédemment montrant les variations en fonction du courant Ib injecté dans la section de Bragg respectivement de la longueur d'onde λ du mode oscillant, du SMSR et de la dérivée dPr/dIa de puissance Pr émise par la face arrière par rapport au courant Ia injecté dans la section active.
- La figure 6 représente un exemple de réalisation d'une source d'émission laser accordable en longueur d'onde selon l'invention.
- La figure 7 représente des chronogrammes montrant les variations en fonction du temps respectivement du courant Ia injecté dans la section active et du courant Ir délivré par un photodétecteur de mesure de la puissance Pr.

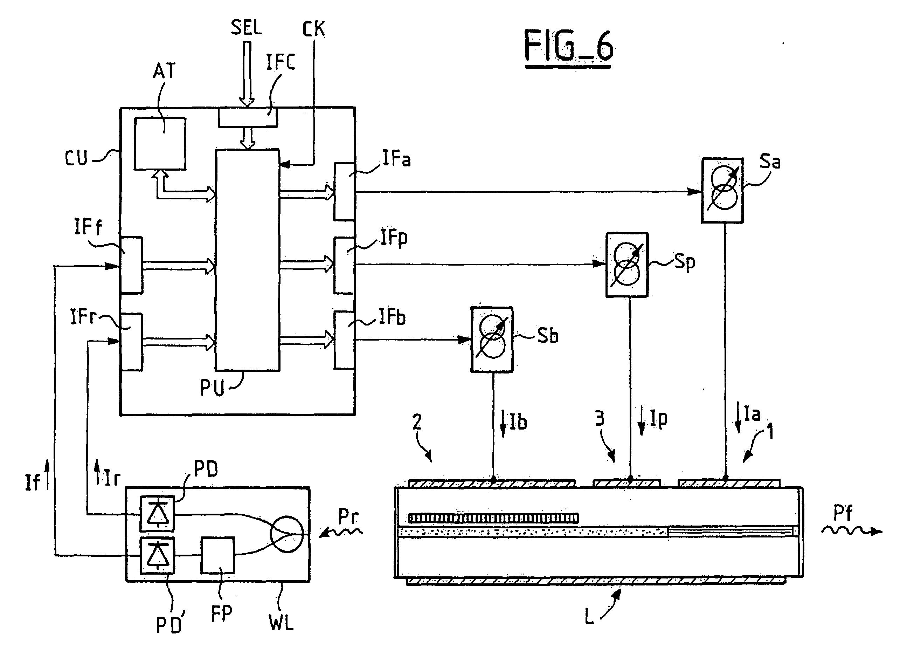

La figure 6 montre un mode de réalisation particulier d'une source d'émission laser conforme à l'invention. La source comporte un composant laser L du premier type mentionné précédemment, associé à un circuit électronique composé d'une unité de commande CU, de sources de courant ajustables Sa, Sb et Sp et d'un dispositif de détection de puissance WL couplé à la face arrière du composant L. Les sections amplificatrice 1, réfléchissante 2 et de phase 3 du laser sont connectées respectivement aux sources Sa, Sb et Sp disposées pour injecter dans ces sections respectivement les courants Ia, Ib et Ip.

Selon la réalisation représentée, la source laser est prévue pour caler automatiquement l'oscillation laser sur des longueurs d'onde normalisées. C'est pourquoi, le dispositif de détection de puissance WL comporte un premier photodétecteur PD recevant directement un partie de la puissance arrière Pr et un second photodétecteur PD' recevant une autre partie de cette puissance par l'intermédiaire d'un filtre étalon périodique FP, par exemple de type Fabry-Pérot, accordé sur les longueurs d'onde normalisées choisies.

L'unité de commande CU est prévue pour commander les sources de courant ajustables Sa, Sb et Sp selon les principes déjà exposés au début de la description. Avantageusement, elle comporte une unité de traitement numérique PU (par exemple à base d'un microcontrôleur programmable de type classique).

Au moyen d'interfaces d'entrée appropriées IFc, IFr, IFf et après conversion analogique-numérique, l'unité de traitement PU accède à des données numériques représentatives respectivement d'une consigne SEL de longueur d'onde sélectionnée et des courants Ir et If délivrés par les photodétecteurs PD et PD'.

L'unité de traitement PU élabore des valeurs de consigne des courants Ia, Ib, Ip que les sources de courant Sa, Sb, Sp doivent fournir. Après conversion numérique-analogique, des signaux de commandes correspondants sont appliqués aux sources de courant ajustables Sa, Sb et Sp au moyen d'interfaces de sortie appropriées IFa, IFb, IFp.

Les valeurs de consigne des courants Ia, Ib, Ip sont déterminés par l'unité PU grâce à la table d'allocation AT (déjà mentionnée en référence à la figure 2) contenue dans une mémoire adressable par l'unité PU. Ainsi, en fonction de la consigne SEL de la longueur d'onde à sélectionner, l'unité PU fournit l'adresse AD à la mémoire et saisit un ensemble de valeurs de paramètres DIa, DIb, DIp représentatives de valeurs de consigne initiales des courants Ia, Ib, Ip à appliquer. Ces valeurs initiales sont ensuite ajustées par les algorithmes d'asservissement prévus dans l'unité PU.

Selon l'exemple décrit, le paramètre DIa constitue la valeur de consigne du courant Ia. Le paramètres DIb constituent la valeur de consigne initiale de Ib qui fixe la longueur d'onde de Bragg et donc sélectionne parmi les modes oscillants de la cavité celui qui présente une longueur d'onde proche de la longueur d'onde indiquée par la consigne SEL. Enfin, le paramètre DIp constitue la valeur de consigne initiales de Ip, mais la valeur de consigne effective est ajustée de façon à rendre maximal le rapport If/Ir des courants Ir et If délivrés respectivement par les photodétecteurs PD et PD', et ainsi caler l'oscillation laser sur une des longueurs d'onde normalisées.

Pour mettre en oeuvre l'invention, des dispositions supplémentaires sont prévues. D'abord la table d'allocation AT comporte à chaque adresse un champs supplémentaire affecté à un paramètre DRef (voir figure 2). Les valeurs du paramètre DRef sont des données représentatives de valeurs de consigne Ref de la dérivée dPr/dIa, associées respectivement aux longueurs d'onde sélectionnables.

Ensuite, l'unité de commande CU doit mettre en oeuvre un procédé pour mesurer la dérivée dPr/dIa de la puissance laser par rapport au courant Ia injecté dans la section amplificatrice 1. Le procédé proposé consiste à moduler périodiquement le courant Ia autour d'une valeur constante Ia0 (correspondant à la valeur du paramètre DIa fourni par la table AT), cette modulation ayant une amplitude prédéterminée, et à mesurer l'amplitude de modulation périodique de la puissance laser qui en résulte.

Ceci est illustré à la figure 7 qui montre les variations en fonction du temps respectivement du courant Ia injecté dans la section active et du courant Ir délivré par le photodétecteur PD. La mesure du courant Ir constituant une mesure de la puissance laser et l'amplitude de modulation ΔIa du courant Ia étant constante et connue, l'amplitude de modulation ΔIr du courant Ir constituera donc une mesure de la dérivée dPr/dIa.

Pour mettre en oeuvre ce procédé de mesure, l'unité de commande CU est alors prévue pour commander la source de courant Sa de façon à moduler périodiquement le courant Ia autour de la valeur constante Ia0. Le rythme de modulation peut être facilement élaboré à partir du signal d'horloge CK que reçoit l'unité PU. La modulation a une amplitude ΔIa prédéterminée et les valeurs du paramètre DRef fournies par la table AT (qui sont les données représentatives des valeurs de consigne Ref) seront donc des valeurs de référence d'amplitude de modulation de la puissance laser. L'unité de commande CU est enfin prévue pour évaluer l'amplitude de modulation périodique de la puissance laser, la comparer à celle des valeurs de référence qui est associée à la longueur d'onde sélectionnée λ_{q} et, en fonction de cette comparaison, réévaluer la commande appliquée à la source de courant ajustables Sb.

En pratique, pour ne pas perturber les signaux optiques qui seront transmis après modulation de l'onde laser produite, il convient que l'amplitude de modulation ΔIa du courant Ia soit faible par rapport à sa valeur moyenne Ia0, par exemple moins de 2 % de Ia0. De même, la fréquence de cette modulation doit être très inférieure aux fréquences d'horloge des signaux transmis.

L'invention n'est pas limitée au mode de réalisation qui vient d'être décrit. Elle peut utiliser divers types de composants laser DB et, au lieu de disposer le détecteur PD pour mesurer la puissance arrière Pr, on pourrait le disposer pour mesurer la puissance avant Pf.

De même, la section réfléchissante 2 décrite comme une section à réflecteur de Bragg conventionnel pourrait comporter un réflecteur de Bragg échantillonné, ou pourrait être remplacée par un structure équivalente telle qu'une section à cristaux photoniques.

## Revendications

1. Procédé pour stabiliser le fonctionnement d'une source d'émission laser accordable en longueur d'onde, ladite source comprenant :
- un composant semi-conducteur (L) muni d'une section amplificatrice (1) délimitée par un premier et un second réflecteur (2, 9) formant une cavité résonante permettant plusieurs modes oscillants qui déterminent respectivement plusieurs longueurs d'onde sélectionnables (λ₁, λ₂, λ_{q}), ledit premier réflecteur étant une section réfléchissante (2) intégrée au composant et présentant un maximum de réflectivité pour au moins une valeur de longueur d'onde de réflexion (λ_{B}), cette section réfléchissante (2) ayant une première extrémité couplée à ladite section amplificatrice (1) et une seconde extrémité (10), un courant électrique (Ia) étant injecté dans ladite section amplificatrice (1), ladite section réfléchissante (2) étant commandable de façon à pouvoir régler ladite valeur de longueur d'onde de réflexion (λ_{B}) et ainsi favoriser l'oscillation d'un desdits modes oscillants présentant une longueur d'onde sélectionnée (λ_{q}) , une puissance laser étant alors créée dans la cavité, ce procédé étant **caractérisée en ce qu'**il consiste à ajuster ladite longueur d'onde de réflexion (λ_{B}) de sorte que pour chaque longueur d'onde sélectionnée (λ_{q}) , la dérivée (dPr/dIa) de ladite puissance laser par rapport au courant (Ia) injecté dans la section amplificatrice (1) soit maintenue égale à une valeur de consigne (Ref) pour laquelle ladite source présente un taux de réjection des modes secondaires (SMSR) voisin de la valeur maximale que ce taux peut prendre pour ladite longueur d'onde sélectionnée (λ_{q}).

2. Procédé selon la revendication 1, **caractérisée en ce que** ladite valeur de consigne (Ref) est une valeur unique commune à toutes les longueurs d'onde sélectionnables (λ₁, λ₂, λ_{q}).

3. Procédé selon la revendication 1, **caractérisée en ce que** chaque longueur d'onde sélectionnable (λ₁, λ₂, λ_{q}) est associée à une valeur de consigne (Ref) spécifique.

4. Procédé selon la revendication 2, **caractérisée en ce que** toute longueur d'onde sélectionnable (λ₁, λ₂, λ_{q}) étant comprise entre deux valeurs de longueurs d'onde de réflexion consécutives (λ_{B}1, λ_{B}2) qui correspondent respectivement à des sauts de mode, ladite valeur de consigne (Ref) a une valeur voisine de celle (Refm) pour laquelle la longueur d'onde de réflexion (λ_{B}) est sensiblement égale à la moyenne (λm) desdites valeurs de longueurs d'onde de réflexion consécutives (λ_{B}1, λ_{B}2) .

5. Procédé selon l'une des revendications 1 à 4, **caractérisée en ce que** pour mesurer ladite dérivée (dPr/dIa) de ladite puissance laser par rapport au courant (Ia) injecté dans la section amplificatrice (1), on module périodiquement ledit courant (Ia) autour d'une valeur constante (Ia0), ladite modulation ayant une amplitude prédéterminée, et on mesure l'amplitude de modulation périodique de ladite puissance laser.

6. Procédé selon l'une des revendications 1 à 5, **caractérisée en ce que** ladite puissance laser est évaluée en mesurant la puissance optique issue de ladite seconde extrémité (10) de la section réfléchissante (2).

7. Procédé selon l'une des revendications 1 à 5, **caractérisée en ce que** ladite puissance laser est évaluée en mesurant la puissance optique issue dudit second réflecteur (9).

8. Source d'émission laser accordable en longueur d'onde, comprenant :
- un composant semi-conducteur (L) muni d'une section amplificatrice (1) délimitée par un premier et un second réflecteur (2, 9) formant une cavité résonante permettant plusieurs modes oscillants qui déterminent respectivement plusieurs longueurs d'onde sélectionnables (λ₁, λ₂, λ_{q}) , ledit premier réflecteur étant une section réfléchissante (2) intégrée au composant et présentant un maximum de réflectivité pour au moins une valeur de longueur d'onde de réflexion (λ_{B}), cette section réfléchissante (2) ayant une première extrémité couplée à ladite section amplificatrice (1) et une seconde extrémité (10), ladite section réfléchissante (2) étant commandable électriquement de façon à pouvoir régler ladite valeur de longueur d'onde de réflexion (λ_{B}),
- un détecteur (PD) pour évaluer une puissance laser créée dans la cavité, et
- un circuit électronique (CU, Sa, Sb) pour injecter un courant électrique (Ia) dans la section amplificatrice (1) et pour commander ladite longueur d'onde de réflexion (λ_{B}) de façon à favoriser l'oscillation d'un desdits modes oscillants présentant une longueur d'onde sélectionnée (λ_{q}), ladite source étant **caractérisée en ce qu'**elle comporte des moyens d'asservissement (WL, CU, Sa, Sb) conçus pour ajuster ladite longueur d'onde de réflexion (λ_{B}) de sorte que pour chaque longueur d'onde sélectionnée (λ_{q}), la dérivée (dPr/dIa) de ladite puissance laser par rapport au courant (Ia) injecté dans la section amplificatrice (1) soit égale à une valeur de consigne (Ref) pour laquelle ladite source présente un taux de réjection des modes secondaires (SMSR) voisin de la valeur maximale que ce taux peut prendre pour ladite longueur d'onde sélectionnée (λ_{q}).

9. Source d'émission laser selon la revendication 8, **caractérisée en ce que** ladite section réfléchissante (2) étant commandable par injection de courant électrique (Ib), ladite source d'émission laser comporte des première et seconde sources de courant ajustables (Sa, Sb) disposées pour injecter des premier et de second courants (Ia, Ib) respectivement dans ladite section amplificatrice (1) et dans ladite section réfléchissante (2), **en ce que** ledit circuit électronique (CU, Sa, Sb) comprend une unité de commande (CU) pour commander lesdites sources de courant ajustables (Sa, Sb) en fonction d'une donnée de consigne (SEL) représentative de ladite longueur d'onde sélectionnée (λ_{q}) et d'une mesure de ladite dérivée (dPr/dIa) de puissance laser, et **en ce que** ladite unité de commande (CU) est munie d'une unité de traitement numérique (PU) coopérant avec une table d'allocation (AT) comportant des données (DRef) représentatives de valeurs de consigne (Ref) associées respectivement auxdites longueurs d'onde sélectionnables (λ₁, λ₂, λ_{q}).

10. Source d'émission laser selon la revendication 9, **caractérisée en ce que** ladite unité de commande (CU) est prévue pour commander ladite première source de courant (Sa) de façon moduler périodiquement ledit premier courant (Ia) autour d'une valeur constante (Ia0), ladite modulation ayant une amplitude (ΔIa) prédéterminée, lesdites données (DRef) représentatives desdites valeurs de consigne (Ref) étant des valeurs de référence d'amplitude de modulation de puissance laser, **en ce que** l'unité de commande (CU) est prévue pour évaluer l'amplitude de modulation périodique de ladite puissance laser, la comparer à celle desdites valeurs de référence qui est associée à ladite longueur d'onde sélectionnée (λ_{q}) et, en fonction de cette comparaison, réévaluer la commande appliquée à ladite seconde sources de courant ajustables (Sb).

11. Source d'émission laser selon l'une des revendications 8 à 10, **caractérisée en ce que** ledit détecteur (PD) est disposé pour mesurer la puissance optique (Pr) issue de ladite seconde extrémité (10) de la section réfléchissante (2) .

12. Source d'émission laser selon l'une des revendications 8 à 10, **caractérisée en ce que** ledit détecteur (PD) est disposé pour mesurer la puissance optique (Pf) issue dudit second réflecteur (9).

## Claims

1. A method for stabilizing the operation of a laser emission source with tunable wavelength, said source comprising:
- a semiconducting component (L) provided with an amplifying section (1) delimited by a first and a second reflector (2, 9) forming a resonant cavity allowing several oscillating modes which respectively determine several selectable wavelengths (λ₁, λ₂, (λ_{q}) , said first reflector being a reflective section (2) integrated into the component and having maximum reflectivity for at least one reflection wavelength value (λ_{B}), this reflective section (2) having a first end coupled with said amplifying section (1) and a second end (10), an electric current (Iₐ) being injected into said amplifying section (1), said reflective section (2) being controllable so as to be able to adjust said reflection wavelength value (λ_{B}) and to thereby promote the oscillation of one of said oscillating modes having a selected wavelength (λ_{q}), laser power being then generated in the cavity, this method being **characterized in that** it consists of adjusting said reflection wavelength (λ_{B}) so that for each selected wavelength (λ_{q}), the derivative (dPr/dIa) of said laser power relatively to the injected current (Ia) in the amplifying section (1) is maintained equal to a set value (Ref) for which said source has a side mode rejection rate (SMSR) close to the maximum value that this rate may assume for said selected wavelength (λ_{q}).

2. The method according to claim 1, **characterized in that** said set value (Ref) is a single value common to all the selectable wavelengths (λ₁, λ₂, λ_{q}).

3. The method according to claim 1, **characterized in that** each selectable wavelength (λ₁, λ₂, λ_{q}) is associated with a specific set value (Ref).

4. The method according to claim 2, **characterized in that** as any selectable wavelength (λ₁, λ₂, λ_{q}) is comprised between two values of consecutive reflection wavelengths (λ_{B}1, λ_{B}2) which respectively correspond to mode jumps, said set value (Ref) has a value close to the one (Refm) for which the reflection wavelength (λ_{B}) is substantially equal to the average (λₘ) of said consecutive reflection wavelength values (λ_{B}1, λ_{B}2).

5. The method according to any of claims 1 to 4, **characterized in that** for measuring said derivative (dPr/dIa) of said laser power relatively to the current (Ia) injected into the amplifying section (1), said current (Ia) is periodically modulated around a constant value (Ia0), said modulation having a predetermined amplitude, and the periodic modulation amplitude of said laser power is measured.

6. The method according to any of claims 1 to 5, **characterized in that** said laser power is evaluated by measuring the optical power from said second end (10) of the reflective section (2).

7. The method according to any of claims 1 to 5, **characterized in that** said laser power is evaluated by measuring the optical power from said second reflector (9).

8. A laser emission source with tunable wavelength, comprising:
- a semi-conducting component (L) provided with an amplifying section (1) delimited by a first and a second reflector (2, 9) forming a resonant cavity allowing several oscillating modes which respectively determine several selectable wavelengths (λ₁, λ₂, λ_{q}), said first reflector being a reflective section (2) integrated into the component and having maximum reflectivity for at least one reflection wavelength value (λ_{B}), this reflective section (2) having a first end coupled with said amplifying section (1) and a second end (10), said reflective section (2) being electrically controllable so as to be able to adjust said reflection wavelength value (λ_{B}),
- a detector (PD) for evaluating laser power generated in the cavity, and
- an electronic circuit (CU, Sa, Sb) for injecting an electric current (Ia) into the amplifying section (1) and for controlling said reflection wavelength (λ_{B}), so as to promote the oscillation of one of said oscillating modes having a selected wavelength (λ_{q}), said source being **characterized in that** it includes servocontrol means (WL, CU, Sa, Sb) designed for adjusting said reflection wavelength (λ_{B}) so that for each selected wavelength (λ_{q}), the derivative (dPr/dIa) of said laser power relatively to the current (Ia) injected into the amplifying section (1) is equal to a set value (Ref) for which said source has a side mode rejection rate (SMSR) close to the maximum value that this rate may assume for said selected wavelength (λ_{q}).

9. The laser emission source according to claim 8, **characterized in that** as said reflective section (2) is controllable by injecting an electric current (Ib), said laser emission source includes first and second adjustable current sources (Sa, Sb) positioned for respectively injecting first and second currents (Ia, Ib) into said amplifying section (1) and into said reflective section (2), **in that** said electronic circuit (CU, Sa, Sb) comprises a control unit (CU) for controlling said adjustable current sources (Sa, Sb) depending on a set datum (SEL) representative of said selected wavelength (λ_{q}) and on a measurement of said laser power derivative (dPr/dIa), and **in that** said control unit (CU) is provided with a digital processing unit (PU) cooperating with an allocation table (AT) including data (DRef) representative of set values (Ref) respectively associated with said selectable wavelengths (λ₁, λ₂, λ_{q}).

10. The laser emission source according to claim 9, **characterized in that** said control unit (CU) is provided in order to control said first current source (Sa) in order to periodically modulate said first current (Ia) around a constant value (Ia0), said modulation having a predetermined amplitude (ΔIa) , said representative data (DRef) of said set values (Ref) being laser power modulation amplitude reference values, **in that** the control unit (CU) is provided for evaluating the periodic modulation amplitude of said laser power, comparing it with the one of said reference values, which is associated with said selected wavelength (λ_{q}) and, depending on this comparison, re-evaluating the control applied to said second adjustable current sources (Sb).

11. The laser emission source according to any of claims 8 to 10, **characterized in that** said detector (PD) is positioned for measuring the optical power (Pr) from said second end (10) of the reflective section (2).

12. The laser emission source according to any of claims 8 to 10, **characterized in that** said detector (PD) is positioned for measuring the optical power (Pf) from said second reflector (9).

## Patentansprüche

1. Verfahren zum Stabilisieren des Betriebs einer wellenlängenabstimmbaren Laseremissionsquelle, wobei die Quelle folgendes umfasst:
- ein Halbleiterbauelement (L), das mit einem Verstärkerabschnitt (1) versehen ist, der von einem ersten und einem zweiten Reflektor (2, 9) begrenzt ist, die einen Resonanzhohlraum bilden, der mehrere Schwingungsmodi ermöglicht, die jeweils mehrere auswählbare Wellenlängen (λ₁, λ₂, λ_{q}) bestimmen, wobei der erste Reflektor ein reflektierender Abschnitt (2) ist, der in das Bauelement integriert ist und für mindestens einen Wert der Reflexionswellenlänge (λ_{B}) einen maximalen Reflexionsgrad aufweist, wobei dieser reflektierende Abschnitt (2) ein erstes Ende, das mit dem Verstärkerabschnitt (1) gekoppelt ist, und ein zweites Ende (10) aufweist, wobei ein elektrischer Strom (Ia) in den Verstärkerabschnitt (1) eingekoppelt wird, wobei der reflektierende Abschnitt (2) steuerbar ist, um den Wert der Wert der Reflexionswellenlänge (λ_{B}) einstellen zu können und somit die Schwingung eines der Schwingungsmodi, der eine ausgewählte Wellenlänge (λ_{q}) aufweist, begünstigen zu können, wobei dann eine Laserleistung in dem Hohlraum erstellt wird,
wobei dieses Verfahren **dadurch gekennzeichnet ist, dass** es darin besteht, die Reflexionswellenlänge (λ_{B}) anzupassen, so dass für jede ausgewählte Wellenlänge (λ_{q}), die Ableitung (dPr/dIa) der Laserleistung im Verhältnis zu dem Strom (Ia), der in den Verstärkerabschnitt (1) eingekoppelt wird, auf einem Sollwert (Ref) gehalten wird, für den die Quelle ein Nebenmodus-Unterdrückungsverhältnis (SMSR) aufweist, das nahe an dem Höchstwert liegt, den dieses Verhältnis für die ausgewählte Wellenlänge (λ_{q}) annehmen kann.

2. Verfahren nach Anspruch 1, **dadurch gekennzeichnet, dass** der Sollwert (Ref) ein einzigartiger Wert ist, der allen auswählbaren Wellenlängen (λ₁, λ₂, λ_{q}) gemeinsam ist.

3. Verfahren nach Anspruch 1, **dadurch gekennzeichnet, dass** jede auswählbare Wellenlänge (λ₁, λ₂, λ_{q}) mit einem spezifischen Sollwert (Ref) verknüpft ist.

4. Verfahren nach Anspruch 2, **dadurch gekennzeichnet, dass** wenn jede beliebige auswählbare Wellenlänge (λ₁, λ₂, λ_{q}) zwischen zwei aufeinanderfolgenden Werten von Reflexionswellenlängen (λ_{B}1, λ_{B}2) liegt, die jeweils Modensprüngen entsprechen, der Sollwert (Ref) einen Wert aufweist, der nahe an demjenigen (Refm) liegt, für den die Reflexionswellenlänge (λ_{B}) im Wesentlichen gleich dem Mittelwert (λm) der aufeinanderfolgenden Werte von Reflexionswellenlängen (λ_{B}1, λ_{B}2) ist.

5. Verfahren nach einem der Ansprüche 1 bis 4, **dadurch gekennzeichnet, dass** zum Messen der Ableitung (dPr/dIa) der Laserleistung im Verhältnis zu dem Strom (Ia), der in den Verstärkerabschnitt (1) eingekoppelt wird, der Strom (Ia) periodisch um einen konstanten Wert (Ia0) moduliert wird, wobei die Modulation eine vorherbestimmte Amplitude aufweist, und die periodische Modulationsamplitude der Laserleistung gemessen wird.

6. Verfahren nach einem der Ansprüche 1 bis 5, **dadurch gekennzeichnet, dass** die Laserleistung bewertet wird, indem die optische Leistung aus dem zweiten Ende (10) des reflektierenden Abschnitts (2) gemessen wird.

7. Verfahren nach einem der Ansprüche 1 bis 5, **dadurch gekennzeichnet, dass** die Laserleistung bewertet wird, indem die optische Leistung aus dem zweiten Reflektor (9) gemessen wird.

8. Wellenlängenabstimmbare Laseremissionsquelle, umfassend:
- ein Halbleiterbauelement (L), das mit einem Verstärkerabschnitt (1) versehen ist, der von einem ersten und einem ersten Reflektor (2, 9) begrenzt ist, die einen Resonanzhohlraum bilden, der mehrere Schwingungsmodi ermöglicht, die jeweils mehrere auswählbare Wellenlängen (λ₁, λ₂, λ_{q}) bestimmen, wobei der erste Reflektor ein reflektierender Abschnitt (2) ist, der in das Bauelement integriert ist und für mindestens einen Wert der Reflexionswellenlänge (λ_{B}) einen maximalen Reflexionsgrad aufweist, wobei dieser reflektierende Abschnitt (2) ein erstes Ende, das mit dem Verstärkerabschnitt (1) gekoppelt ist, und ein zweites Ende (10) aufweist, wobei der reflektierende Abschnitt (2) elektrisch steuerbar ist, um den Wert der Reflexionswellenlänge (λ_{B}) einstellen zu können,
- einen Detektor (PD) zum Bewerten einer in dem Hohlraum erstellten Laserleistung, und
- eine elektronische Schaltung (CU, Sa, Sb) zum Einkoppeln eines elektrischen Stroms (Ia) in den Verstärkerabschnitt (1) und zum Steuern der Reflexionswellenlänge (λ_{B}), um die Schwingung eines der Schwingungsmodi, der eine ausgewählte Wellenlänge (λ_{q}) aufweist, zu begünstigen,
wobei die Quelle **dadurch gekennzeichnet ist, dass** sie Rückführungsmittel (WL, CU, Sa, Sb) umfasst, die ausgelegt sind, um die Reflexionswellenlänge (λ_{B}) anzupassen, so dass für jede ausgewählte Wellenlänge (λ_{q}) die Ableitung (dPr/dIa) der Laserleistung im Verhältnis zu dem Strom (Ia), der in den Verstärkerabschnitt (1) eingekoppelt wird, gleich einem Sollwert (Ref) ist, für den die Quelle ein Nebenmodus-Unterdrückungsverhältnis (SMSR) aufweist, das nahe an dem Höchstwert liegt, den dieses Verhältnis für die ausgewählte Wellenlänge (λ_{q}) annehmen kann.

9. Laseremissionsquelle nach Anspruch 8, **dadurch gekennzeichnet, dass** der reflektierende Abschnitt (2) durch Einkopplung von elektrischem Strom (Ib) steuerbar ist, die Laseremissionsquelle erste und zweite anpassbare Stromquellen (Sa, Sb) umfasst, die angeordnet sind, um erste und zweite Ströme (Ia, Ib) jeweils in den Verstärkerabschnitt (1) und in den reflektierenden Abschnitt (2) einzukoppeln, dass die elektronische Schaltung (CU, Sa, Sb) eine Steuereinheit (CU) umfasst, um die anpassbaren Stromquellen (Sa, Sb) in Abhängigkeit von einem Solldatenelement (SEL), das für die ausgewählte Wellenlänge (λ_{q}) repräsentativ ist, und einer Messung der Ableitung (dPr/dIa) der Laserleistung zu steuern, und dass die Steuereinheit (CU) mit einer digitalen Verarbeitungseinheit (PU) versehen ist, die mit einer Zuweisungstabelle (AT) zusammenwirkt, die Daten (DRef) umfasst, die für Sollwerte (Ref) repräsentativ sind, die jeweils mit den auswählbaren Wellenlängen (λ₁, λ₂, λ_{q}) verknüpft sind.

10. Laseremissionsquelle nach Anspruch 9, **dadurch gekennzeichnet, dass** die Steuereinheit (CU) bereitgestellt wird, um die erste Stromquelle (Sa) zu steuern, um den ersten Strom (Ia) periodisch um einen konstanten Wert (Ia0) zu modulieren, wobei die Modulation eine vorherbestimmte Amplitude (ΔIa) aufweist, wobei die Daten (DRef), die für die Sollwerte (Ref) repräsentativ sind (Ref) Bezugswerte der Modulationsamplitude der Laserleistung sind, dass die Steuereinheit (CU) bereitgestellt wird, um die periodische Modulationsamplitude der Laserleistung zu bewerten, sie mit demjenigen der Bezugswerte zu vergleichen, der mit der ausgewählten Wellenlänge (λ_{q}) verknüpft ist und in Abhängigkeit von diesem Vergleich die Steuerung, die auf die zweiten anpassbaren Stromquellen (Sb) angewendet wird, neu zu bewerten.

11. Laseremissionsquelle nach einem der Ansprüche 8 bis 10, **dadurch gekennzeichnet, dass** der Detektor (PD) angeordnet ist, um die optische Leistung (Pr) zu messen, die aus dem zweiten Ende (10) des reflektierenden Abschnitts (2) stammt.

12. Laseremissionsquelle nach einem der Ansprüche 8 bis 10, **dadurch gekennzeichnet, dass** der Detektor (PD) angeordnet ist, um die optische Leistung (Pf) zu messen, die aus dem zweiten Reflektor (9) stammt.
